# EUROPÄISCHE PATENTSCHRIFT

(11) **EP 1 355 163 B1**
(45) Veröffentlichungstag und Bekanntmachung des Hinweises auf die Patenterteilung: **12.11.2008**
(21) Anmeldenummer: 03005651.9
(22) Anmeldetag: 13.03.2003
(51) Int. Cl.: G01R 31/42, G01R 31/02, G01R 31/28

(54) **Verfahren und Vorrichtung zum Überprüfen eines Umrichters**
Process and apparatus for testing a converter
Procédé et dispositif pour tester un convertisseur

(30) Priorität: 16.04.2002 DE 10216986
(43) Veröffentlichungstag der Anmeldung: 22.10.2003
(73) Patentinhaber: Dr. Johannes Heidenhain GmbH, 83292 Traunreut (DE)
(72) Erfinder: Kranitzky, Walter, 83278 Traunstein (DE)

(56) Entgegenhaltungen:
- EP-A- 0 142 563
- EP-A- 0 534 362
- EP-A- 0 652 445
- EP-A- 0 848 492
- US-A- 5 510 725
- US-B1- 6 291 987

## Beschreibung

Die Erfindung betrifft ein Verfahren zum Überprüfen eines Umrichters. Solche Verfahren dienen dazu, im Falle eines Fehlers die Fehlerquelle zu lokalisieren. Ferner betrifft die Erfindung eine zugehörige Vorrichtung.

In modernen Werkzeugmaschinen werden elektrische Antriebe verwendet, um verschiedene Maschinenteile kontrolliert zu bewegen. So sorgen die Achsantriebe dafür, daß die einzelnen Achsen der Werkzeugmaschine in die geforderten Positionen bewegt werden, Spindelantriebe sorgen für die Drehbewegung eines Werkzeuges wie Fräskopf oder Bohrer. Eine Numerische Steuerung setzt hierzu die im Teileprogramm vorgegebenen Bewegungen in Lagesollwerte um, die einer Regeleinheit aus Lage-, Drehzahlund Stromregler übergeben werden. Im Strömregler werden Spannungssollwerte für einzelne Motorphasen generiert, die von einem Umrichter über die sogenannte Pulsweitenmodulation umgesetzt werden. Im Umrichter sind hierzu die Phasen des Motors über je zwei Schaltelemente mit der positiven und negativen Versorgungsspannung verbunden. Die Schalter werden nach dem Muster der Pulsweitenmodulation geeignet geschaltet, um an jeder Phase eines Motors das geforderte Spannungspotential zu erzeugen, das nötig ist, um die Stromsollwerte zu erreichen.

In einem solchermaßen komplex aufgebauten System gibt es zahlreiche Fehlerquellen, die zu einem Fehlverhalten führen können. Es sind daher Verfahren bekannt, mit denen ein solcher Fehler erkannt werden kann.

So beschreibt die EP 0 848 492 A1 ein Verfahren zum Erkennen eines Fehlverhaltens in einem Antriebssystem der oben beschriebenen Art. Hierzu werden selektiv einzelne Phasen des Motors mit einem Sollstrom beaufschlagt. Falls der vorgegeben Sollstrom nicht erreicht wird, so wird auf einen Fehler im System geschlossen. Nachteilig an diesem Verfahren ist, daß nach dem Erkennen eines Fehlers nicht klar ist, wo der Fehler liegt. Es kann nicht unterschieden werden zwischen einem Fehler im Umrichter und z.B. einem Kurzschluß oder einer Leitungsunterbrechung außerhalb des Umrichters. Es besteht daher ein Bedarf an speziellen Verfahren, mit denen die Funktionsfähigkeit einzelner Komponenten, insbesondere des Umrichters, überprüft werden kann.

Das Dokument EP 0 534 362 A2 offenbart ein Verfahren zum Überprüfen eines Umrichters, bei dem einzelne Schaltelemente mit des Umrichters mit selektiv aktiviert werden, folgenden Schritten
(a) Beaufschlagen eines Steuereinganges jeder Phase des Umrichters mit einem Steuerungsmuster,
(b) Erfassen eines an einem Motoranschluß des Umrichters auftretenden Spannungsmusters,
(c) Erkennen eines Fehlers im Umrichter bei Abweichung des am Motoranschluß erfaßten Spannungsmusters vom aufgrund des am Steuerungseingang angelegten Steuerungsmusters erwarteten Spannungsmuster,
sowie eine zugehörige Vorrichtung.

Aufgabe der Erfindung ist es denen, ein einfaches Verfahren und eine Vorrichtung anzugeben, mit ein Umrichter auf seine Funktionsfähigkeit überprüft werden kann.

Diese Aufgabe wird gelöst durch ein Verfahren bzw. durch eine Vorrichtung mit den Merkmalen des unabhängigen Ansprüche 1 und 5. Vorteilhafte Details ergeben sich aus den abhängigen Ansprüchen.

Es wird nun ein Verfahren zum Überprüfen eines Umrichters vorgeschlagen, mit dem der Umrichter auf seine Funktionsfähigkeit überprüft werden kann.

In einem ersten Schritt werden einzelne Schaltelemente des Umrichters selektiv aktiviert, indem der Steuereingang jeder Phase des Umrichters mit einem Steuerungsmuster beaufschlagt wird. Im nächsten Schritt wird das an den Motoranschlüssen des Umrichters auftretende Spannungsmuster für jede Phase erfaßt. Weiter vergleicht man das angelegte Steuerungsmuster mit dem erfaßten Spannungsmuster für jede Phase. Bei Abweichung eines am Motoranschluß festgestellten Spannungsmusters vom aufgrund des am Steuereingang angelegten Steuerungsmusters erwarteten Spannungsmuster wird ein Fehler im Umrichter erkannt.

Da am Motoranschluß jeder Phase sehr hohe Spannung anliegen, müssen diese Anschlüsse galvanisch getrennt sein von der die Überprüfung vornehmenden Einrichtung. Dies wird vorteilhaft auf besonders einfache Weise dadurch gelöst, daß Prüfleitungen kapazitiv mit den Motoranschlüssen gekoppelt werden. Es kann hierzu genügen, die Prüfleitungen lediglich in der Nähe der Motoranschlüsse zu verlegen. Außerdem ist es mit dem beschriebenen Verfahren möglich, alle Phasen des Umrichters mit lediglich einer einzigen Prüfleitung zu erfassen, die kapazitiv mit allen Motoranschlüssen gekoppelt wird.

Weitere Vorteile sowie Einzelheiten der vorliegenden Erfindung ergeben sich aus der nachfolgenden Beschreibung eines bevorzugten Verfahrens anhand der Figuren. Dabei zeigt
- Figur 1: ein Schaltbild eines Umrichters,
- Figur 2: ein Verfahren zum Überprüfen eines Umrichters,
- Figur 3: verschiedene Signaldiagramme und
- Figur 4: eine Schaltung zur Auswertung eines Prüfsignals.

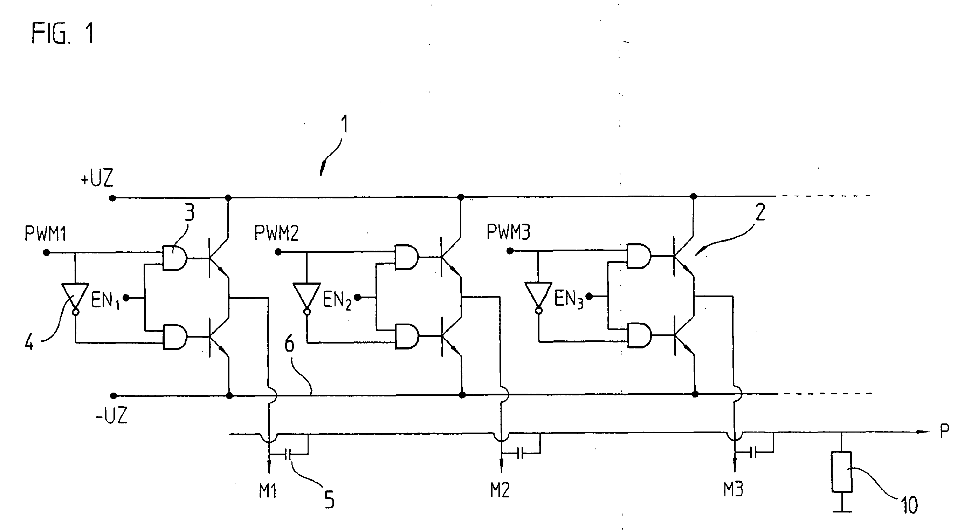

In Figur 1 ist schematisch ein Umrichter 1 dargestellt. Ein solcher Umrichter 1 erzeugt aus einer Gleichspannung eine gepulste Wechselspannung an den Motoranschlüssen M1, M2, M3. Hierzu werden Schaltelemente 2 (z.B. IGBTs) geeignet angesteuert, die jeden Motoranschluß M1, M2, M3 entweder mit dem positiven Potential +Uz oder mit dem negativen Potential -Uz der Gleichspannung verbinden. Pro Motorphase werden ein Motoranschluß M1, M2, M3 und damit zwei Schaltelemente 2 benötigt. Je zwei Schaltelemente 2 eines Motoranschlusses M1, M2, M3 bilden eine Phase des Umrichters. Die Steuerungsmuster, die an den Steuereingängen PWM1, PWM2, PWM3 der Phasen des Umrichters 1 anliegen, aktivieren jeweils eines der beiden Schaltelemente 2 einer Phase des Umrichters 1, falls diese Phase über einen Aktivierungseingang EN1, EN2, EN3 ausgewählt ist. Diese Logik ist in Figur 1 schematisch dargestellt durch den Inverter 4 und die logischen UND-Verknüpfungen 3. Ist eine Phase nicht ausgewählt, so sperren beide Schaltelemente 2 dieser Phase, das Potential des entsprechenden Motoranschlusses M1, M2, M3 ist damit undefiniert. Es kann über diese Phase dann kein Strom fließen. Geeignete Steuerungsmuster sorgen dafür, daß an den nicht dargestellten Motor über eine Pulsweitenmodulation die vom Stromregler vorgegebenen Spannungswerte angelegt werden.

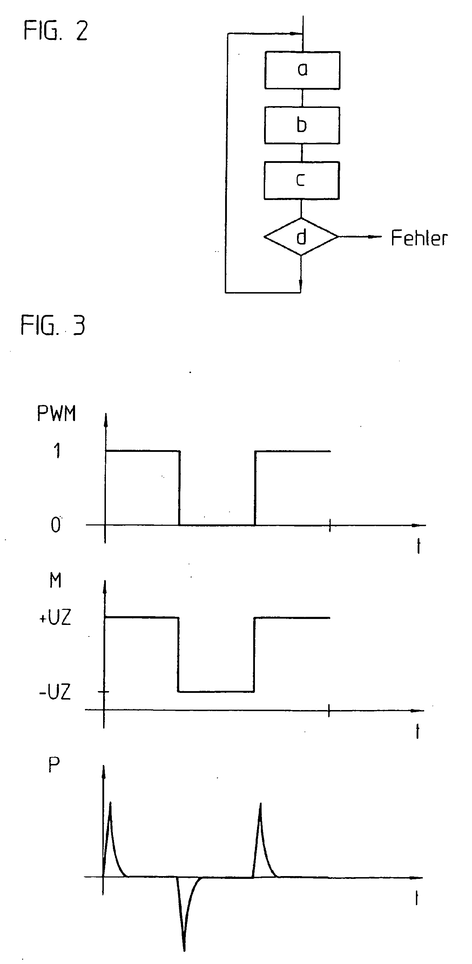

Es soll nun anhand der Figur 2 das Verfahren zur Überprüfung einer Phase des Umrichters 1 beschrieben werden, das Verfahren wiederholt sich für jede der Phasen des Umrichters, wie es in Figur 2 angedeutet ist.

In einem Schritt a wird der Steuereingang PWM1, PWM2, PWM3 einer Phase mit einem geeigneten Steuerungsmuster beaufschlagt, und dabei gleichzeitig diese Phase über den Aktivierungseingang EN1, EN2, EN3 ausgewählt. Die übrigen Phasen bleiben deaktiviert. Ein mögliches Steuerungsmuster PWM ist in Figur 3 dargestellt und läßt sich auch mit 0 - 1 - 0 beschreiben. Bei korrekter Funktion der Logik aus Inverter 4 und UND-Verknüpfungen 3 und der Schaltelemente 2 wird sich am Motoranschluß M1, M2, M3 ein Spannungsmuster M nach Figur 3 ergeben.

In einem Schritt b wird dieses Spannungsmuster M erfaßt. Da wegen der auftretenden hohen Spannungen eine galvanische Trennung der Motoranschlüsse M1, M2, M3 gefordert ist, wird eine Prüfleitung 6 kapazitiv an den Motoranschluß M1, M2, M3 gekoppelt. Dies ist in Figur 1 mit den Kondensatoren 5 angedeutet. Da für einen Kondensator 5 eine Kapazität von wenigen pF ausreicht, wurde eine besonders einfache Lösung gefunden. Es genügt, die Prüfleitung 6 in der Nähe des Motoranschlusses M1, M2, M3 zu verlegen, etwa indem die Prüfleitung 6 den Motoranschluß M1, M2, M3 mit wenigen Windungen umwickelt. Besonders vorteilhaft kann eine einzige Prüfleitung 6 verwendet werden, die kapazitiv an alle Motoranschlüsse M1, M2, M3 gekoppelt ist, da gemäß dem beschriebenen Verfahren immer nur eine Phase des Umrichters 2 aktiviert wird.

Durch die kapazitive Kopplung der Prüfleitung 6 ergibt sich auf der Prüfleitung 6 ein Prüfsignal P entsprechend der Figur 3, da sich die Prüfleitung 6 mit dem Kondensator 5 und einem zwischen Prüfleitung 6 und Masse geschalteten Widerstand 10 wie ein R-C-Glied verhält, an dessen Eingang das Spannungsmuster M des Motoranschlusses M1, M2, M3 angelegt wird.

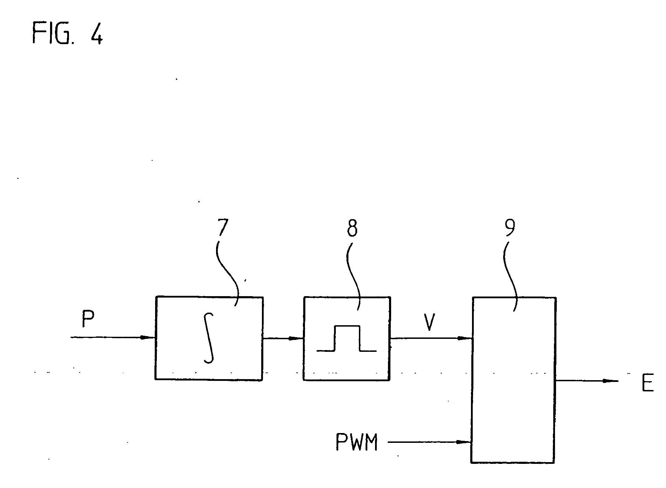

In einem Schritt c wird nun das Prüfsignal P mit dem ursprünglich angelegten Steuerungsmuster PWM verglichen. Dies gelingt besonders einfach, wenn das Prüfsignal P mit einer Schaltung nach Figur 4 mit dem Steuerungsmuster PWM verglichen wird. Mittels eines Integrierers 7 und eines Komparators 8 läßt sich das Prüfsignal P zu einem binären Vergleichssignal V umformen, das dem Steuerungsmuster PWM entspricht. In der Mustervergleichslogik 9 muß daher nur die Gleichheit des Steuerungsmusters PWM und des Vergleichssignals V überprüft und ein entsprechendes Ergebnis E ausgegeben werden.

Sind die Signale gleich, so wird im Schritt d erkannt, daß die gerade überprüfte Phase des Umrichters (1) korrekt arbeitet, es kann zur Überprüfung der nächsten Phase verzweigt werden. Weichen die Signale voneinander ab (wobei kleine Laufzeitunterschiede schon wegen des R-C-Gliedes toleriert werden müssen), so wird eine fehlerhafte Phase erkannt. Es kann eine entsprechende Fehlermeldung generiert werden. Das Verfahren kann an dieser Stelle abgebrochen werden, oder es können die restlichen Phasen des Umrichters (1) auf weitere Fehler überprüft werden.

Es ist zu erwähnen, daß bei der Überprüfung einer Phase des Umrichters 1 die übrigen Phasen deaktiviert sein sollten. Nur so ist sichergestellt, daß z.B. ein Defekt in einem angeschlossenen Motor nicht zu einer Fehlererkennung im beschriebenen Verfahren führt. Dies bedeutet aber auch, daß das beschriebene Verfahren Vorteilhafterweise bei angeschlossenem Motor möglich ist und dennoch lediglich die Überprüfung des Umrichters 1 erfolgt.

Das Verfahren eignet sich für Umrichter 1 mit einer beliebigen Anzahl von Phasen, es genügt im beschriebenen Ausführungsbeispiel eine einzige Prüfleitung 6. Die in Figur 4 beschriebe Schaltung zum Umformen und Vergleichen des Steuerungsmusters PWM und des Prüfsignals P ist mit einfachen Mitteln als diskrete Schaltung zu realisieren, oder kann auch als Software in der Numerischen Steuerung realisiert werden, die den Antrieb mit dem Umrichter 1 ansteuert. Diese Numerische Steuerung kann vorteilhaft zur Steuerung des gesamten Verfahrens eingesetzt werden, wenn sie entsprechend eingerichtet ist.

## Patentansprüche

1. Verfahren zum Überprüfen eines Umrichters, bei dem einzelne Schaltelemente (2) des Umrichters (1) selektiv aktiviert werden, mit folgenden Schritten :
(a) Beaufschlagen eines Steuereingangs (PWM1, PWM2, PWM3) jeder Phase des Umrichters (1) mit einem Steuerungsmuster (PWM).
(b) Erfassen eines an einem Motoranschluß (M1, M2, M3) des Umrichters (1) auftretenden Spannungsmusters (M) durch eine kapazitiv an alle Motoranschlüsse (M1, M2, M3) gekoppelte einzige Prüfleitung (6).
(c) Vergleichen des im Schritt (a) angelegten Steuerungsmusters (PWM) mit dem in Schritt (b) erfaßten Spannungsmuster (M) für jede Phase.
(d) Erkennen eines Fehlers im Umrichter (1) bei Abweichung des am Motoranschluß (M1, M2, M3) erfaßten Spannungsmusters (M) vom aufgrund des am Steuerungseingang (PWM1, PWM2, PWM3) angelegten Steuerungsmusters (PWM) erwarteten Spannungsmuster (M).

2. Verfahren nach Anspruch 1, **dadurch gekennzeichnet, daß** ein Prüfsignal (P) der Prüfleitung (6) in ein Vergleichsmuster (V) umgewandelt wird, das dem Steuerungsmuster(PWM) entspricht.

3. Verfahren nach Anspruch 2, **dadurch gekennzeichnet, daß** das Prüfsignal (P) mittels eines Integrierers (7) und eines Komparators (8) in das Vergleichsmuster (V) umgewandelt wird.

4. Verfahren nach Anspruch 2 oder 3, **dadurch gekennzeichnet, daß** im Schritt (c) das Vergleichsmuster (V) in einer Mustervergleichslogik (9) mit dem Steuerungsmuster (PWM) verglichen wird.

5. Antriebseinheit mit Numerischer Steuerung und Umrichter (1), eingerichtet für ein Verfahren zum Überprüfen eines Umrichters, bei dem einzelne Schaltelemente (2) des Umrichters (1) selektiv aktiviert werden, mit
• Mitteln zum Beaufschlagen eines Steuereinganges (PWM1, PWM2, PWM3) jeder Phase des Umrichters (1) mit einem Steuerungsmuster (PWM);
• Mitteln zum Erfassen eines an einem Motoranschluß (M1, M2, M3) des Umrichters (1) auftretenden Spannungsmusters (M) durch eine kapazitiv an alle Motoranschlüsse (M1, M2, M3) gekoppelte einzige Prüfleitung (6).
• Mitteln zum Vergleichen des Steuerungsmusters (PWM) mit dem Spannungsmuster (M) für jede Phase;
• Mitteln zum Erkennen eines Fehlers im Umrichter (1) bei Abweichung des am Motoranschluß (M1, M2, M3) erfaßten Spannungsmusters (M) vom aufgrund des am Steuerungseingang (PWM1, PWM2, PWM3) angelegten Steuerungsmusters (PWM) erwarteten Spannungsmuster (M).

## Claims

1. A method for the testing of a converter, in which individual circuit elements (2) of the converter (1) are selectively activated, with the following steps:
(a) Application of a control function (PWM) to a control input (PWM1, PWM2, PWM3) of each phase of the converter (1),
(b) Recording of a voltage function (M) occurring at a motor connection (M1, M2, M3) of the converter (1) by means of a single test line (6) coupled capacitively to all motor connections (M1, M2, M3),
(c) Comparison of the control function (PWM) applied in step (a) with the voltage function (M) recorded in step (b) for each phase,
(d) Detection of a fault in the converter (1) in the event of a deviation of the voltage function (M) recorded at the motor connection (M1, M2, M3) from the voltage function (M) expected from the application of the control function (PWM) to the control input (PWM1, PWM2, PWM3).

2. The method according to Claim 1, **characterised in that** a test signal (P) of the test line (6) is converted into a comparison function (V) that corresponds to the control function (PWM).

3. The method according to Claim 2, **characterised in that** the test signal (P) of the test line (6) is converted into the comparison function (V) by means of an integrator (7) and a comparator (8).

4. The method according to Claim 2 or 3, **characterised in that** in step (c) the comparison function (V) is compared with the control function (PWM) in a function comparison logic circuit (9).

5. A drive unit with numerical control and converter (1), equipped for a method for the testing of a converter, in which individual circuit elements (2) of the converter (1) are selectively activated, with:
- means for the application of a control function (PWM) on a control input (PWM1, PWM2, PWM3) of each phase of the converter (1) ;
- means for the recording of a voltage function (M) occurring at a motor connection (M1, M2, M3) of the converter (1) by means of a single test line (6) coupled capacitively to all motor connections (M1, M2, M3);
- means for the comparison of the control function (PWM) with the voltage function (M) for each phase;
- means for the detection of a fault in the converter (1) in the event of a deviation of the voltage function (M) recorded at the motor connection (M1, M2, M3) from the voltage function (M) expected from the application of the control function (PWM) at the control input (PWM1, PWM2, PWM3).

## Revendications

1. Procédé permettant de contrôler un convertisseur de fréquence, dans lequel différents éléments de commutation (2) du convertisseur de fréquence (1) peuvent être activés de manière sélective, avec les étapes suivantes :
(a) alimentation d'une entrée de commande (PWM1, PWM2, PWM3) de chaque phase du convertisseur de fréquence (1) avec un modèle de commande (PWM).
(b) détection d'un modèle de tension (M) apparaissant sur un raccordement moteur (M1, M2, M3) du convertisseur de fréquence (1), par une unique ligne de contrôle (6) couplée de manière capacitive à tous les raccordements moteur (M1, M2, M3).
(c) comparaison du modèle de commande (PWM) appliqué à l'étape (a) avec le modèle de tension (M) détecté à l'étape (b), pour chaque phase.
(d) reconnaissance d'une erreur dans le convertisseur de fréquence (1), lors d'un écart du modèle de tension (M) détecté sur le raccordement moteur (M1, M2, M3) par rapport au modèle de tension (M) attendu à partir du modèle de commande (PWM) appliqué à l'entrée de commande (PWM1, PWM2, PWM3).

2. Procédé selon la revendication 1, **caractérisé en ce qu'**un signal de contrôle (P) de la ligne de contrôle (6) est transformé en un modèle comparatif (V), correspondant au modèle de commande (PWM).

3. Procédé selon la revendication 2, **caractérisé en ce qu'**un signal de contrôle (P) est transformé en un modèle comparatif (V) au moyen d'un intégrateur (7) et d'un comparateur (8).

4. Procédé selon la revendication 2 ou 3, **caractérisé en ce qu'**à l'étape (c), le modèle comparatif (V) est comparé au modèle de commande (PWM) dans une logique de comparaison de modèles (9).

5. Unité d'actionnement avec une commande numérique et un convertisseur de fréquence (1), conçue pour un procédé permettant de contrôler un convertisseur de fréquence, procédé dans lequel différents éléments de commutation (2) du convertisseur de fréquence (1) peuvent être activés de manière sélective, avec :
• des moyens d'alimentation d'une entrée de commande (PWM1, PWM2, PWM3) de chaque phase du convertisseur de fréquence (1) avec un modèle de commande (PWM) ;
• des moyens de détection d'un modèle de tension (M) produit sur un raccordement moteur (M1, M2, M3) du convertisseur de fréquence (1), par une unique ligne de contrôle (6) couplée de manière capacitive à tous les raccordements moteur (M1, M2, M3) ;
• des moyens de comparaison du modèle de commande (PWM) avec le modèle de tension (M), pour chaque phase ;
• des moyens de reconnaissance d'une erreur dans le convertisseur de fréquence (1), lors d'un écart du modèle de tension (M) détecté sur le raccordement moteur (M1, M2, M3) par rapport au modèle de tension (M) attendu à partir du modèle de commande (PWM) appliqué à l'entrée de commande (PWM1, PWM2, PWM3).
